# EUROPEAN PATENT APPLICATION

(11) **EP 4 734 677 A1**
(43) Date of publication of application: **29.04.2026**
(21) Application number: 24856819.8
(22) Date of filing: 22.08.2024
(51) Int. Cl.: H05K 5/02, H05K 9/00, H04M 1/04, H02J 50/10, G06F 3/041, H01F 27/36, H01F 13/00, H02J 50/00, H01F 7/02

(54) **ELECTRONIC DEVICE INCLUDING MAGNET, AND CASE DEVICE**

(30) Priority: 23.08.2023 KR 20230110808; 02.01.2024 KR 20240000448
(71) Applicant: Samsung Electronics Co., Ltd., Suwon-si, Gyeonggi-do 16677 (KR)
(72) Inventor: CHOE, Hana, Suwon-si, Gyeonggi-do 16677 (KR); LIM, Taejun, Suwon-si, Gyeonggi-do 16677 (KR); PARK, Bumjin, Suwon-si, Gyeonggi-do 16677 (KR); YOU, Jaehyoung, Suwon-si, Gyeonggi-do 16677 (KR); LEE, Woosup, Suwon-si, Gyeonggi-do 16677 (KR); CHOI, Sehwan, Suwon-si, Gyeonggi-do 16677 (KR)
(74) Representative: Gulde & Partner
(86) International application number: PCT/KR2024/012483
(87) International publication number: WO 2025/042208

(57) **Abstract**

According to various embodiments of the disclosure, an electronic device may include a display (330), a coil (370), a magnet assembly (373) including a plurality of first magnets (610) disposed to surround the coil (370) and a plurality of second magnets (620) disposed to be spaced a designated distance apart from the plurality of first magnets (610) so as to surround the plurality of first magnets (610), a first shielding sheet (391) extending along the magnet assembly (373) toward the display (330) so as to be attached to the magnet assembly (373), a second shielding sheet (392) disposed between the coil (370) and the display (330) toward the display (330) from the first shielding sheet (391), and a third shielding sheet (393) disposed between the display and the second shielding sheet. Various other embodiments may be provided in addition to the various embodiments of the disclosure.

## Description

### [TECHNICAL FIELD]_

Various embodiments of the disclosure relate to an electronic device and a case device including magnets.

### [BACKGROUND ART]

Electronic devices may include a coil that supports wireless charging. The electronic device may be equipped with a magnet disposed around the coil, or a case device having a magnet. For example, when an electronic device is placed on an attachable wireless charger for charging, the magnet may enable the electronic device to be disposed in alignment with the attachable wireless charger.

The above information is presented as background information only to assist with an understanding of the disclosure. No determination has been made, and no assertion is made, as to whether any of the above might be applicable as prior art with regard to the disclosure.

### [DISCLOSURE OF INVENTION]

### [Technical Solution]

In accordance with an aspect of the disclosure, an electronic device is provided. The electronic device includes a display, a coil, a magnet assembly including a plurality of first magnets disposed to surround the coil and a plurality of second magnets disposed to be spaced a designated distance apart from the plurality of first magnets so as to surround the plurality of first magnets, a first shielding sheet extending along the magnet assembly toward the display so as to be attached to the magnet assembly, a second shielding sheet disposed between the coil and the display toward the display from the first shielding sheet, and a third shielding sheet disposed between the display and the second shielding sheet.

In accordance with another aspect of the disclosure, a case device 401 is provided. The case device includes a magnet assembly including a plurality of first magnets disposed to face the electronic device including a coil and surround the coil, and a plurality of second magnets disposed to be spaced a designated distance apart from the plurality of first magnets so as to surround the plurality of first magnets, and a shielding sheet extending along the magnet assembly toward the electronic device and attached to the magnet assembly.

Other aspects, advantages, and salient features of the disclosure will become apparent to those skilled in the art from the following detailed description, which, taken in conjunction with the annexed drawings, discloses various embodiments of the disclosure.

### [BRIEF DESCRIPTION OF DRAWINGS]

FIG. 1 is a block diagram of an electronic device in a network environment according to an embodiment of the disclosure;
FIG. 2A is a perspective view of the front of an electronic device according to an embodiment of the disclosure;
FIG. 2B is a perspective view of the rear of the electronic device in FIG. 2A according to an embodiment of the disclosure;
FIG. 3 is an exploded perspective view of an electronic device according to an embodiment of the disclosure;
FIG. 4 is an exploded perspective view of an electronic device and a case device according to an embodiment of the disclosure;
FIG. 5 is a diagram schematically illustrating an operation in which a power transmission device charges a power reception device according to an embodiment of the disclosure;
FIGS. 6A, 6B, and 6C are diagrams illustrating a coil and a plurality of magnets disposed in the inner space of a power reception device according to various embodiments of the disclosure;
FIG. 7 is a diagram illustrating a coil disposed in an inner space of a power reception device and a plurality of magnets disposed in an inner space of a case device according to an embodiment of the disclosure;
FIG. 8 is a cross-sectional view of magnet assemblies of a power transmission device and a power reception device according to an embodiment of the disclosure;
FIG. 9 is a diagram illustrating comparison of changes in magnetic field affecting a digitizer depending on the width of an opening area of a magnet assembly according to an embodiment of the disclosure;
FIGS. 10A and 10B are diagrams illustrating comparison of changes in magnetic field affecting a digitizer depending on the thickness of a first shielding sheet according to an embodiment of the disclosure;
FIG. 11 is a cross-sectional view of a magnet assembly of a power transmission device and a power reception device according to an embodiment of the disclosure;
FIG. 12 is a diagram illustrating comparison of changes in magnetic field affecting a digitizer depending on the thickness of a first shielding sheet according to an embodiment of the disclosure;
FIG. 13 is a diagram illustrating comparison of magnetic-field saturation of a second shielding sheet depending on the magnetization direction of a magnet and the presence or absence of a first shielding sheet according to an embodiment of the disclosure;
FIGS. 14A, 14B, 14C, and 14D are diagrams illustrating comparison of magnetic-field radiation patterns depending on the presence or absence of a first shielding sheet according to an embodiment of the disclosure;
FIGS. 15A, 15B, and 15C are diagrams illustrating at least one specific area disposed on a first shielding sheet according to an embodiment of the disclosure; and
FIGS. 16A and 16B are diagrams illustrating the arrangement position of at least one specific area in a first shielding sheet according to an embodiment of the disclosure.

### [MODE FOR THE INVENTION]

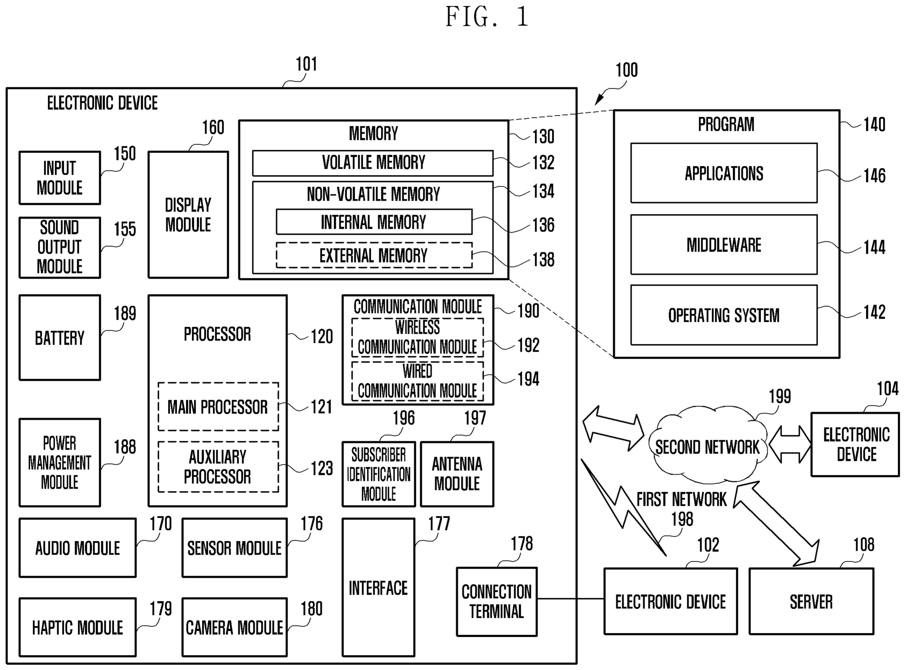

FIG. 1 is a block diagram illustrating an electronic device in a network environment according to an embodiment of the disclosure.

Referring to FIG. 1, an electronic device 101 in a network environment 100 may communicate with an external electronic device 102 via a first network 198 (e.g., a short-range wireless communication network), or at least one of an external electronic device 104 or a server 108 via a second network 199 (e.g., a long-range wireless communication network). According to an embodiment of the disclosure, the electronic device 101 may communicate with the external electronic device 104 via the server 108. According to an embodiment of the disclosure, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments of the disclosure, at least one of the components (e.g., the connecting terminal 178) may be omitted from the electronic device 101, or one or more other components may be added in the electronic device 101. In some embodiments of the disclosure, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment of the disclosure, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment of the disclosure, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., a sleep) state, or together with the main processor 121 while the main processor 121 is in an active state (e.g., executing an application). According to an embodiment of the disclosure, the auxiliary processor 123 (e.g., an image signal processor or a communication processor) may be implemented as part of another component (e.g., the camera module 180 or the communication module 190) functionally related to the auxiliary processor 123. According to an embodiment of the disclosure, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment of the disclosure, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment of the disclosure, the display module 160 may include a touch sensor adapted to detect a touch, or a pressure sensor adapted to measure the intensity of force incurred by the touch.

The audio module 170 may convert a sound into an electrical signal and vice versa. According to an embodiment of the disclosure, the audio module 170 may obtain the sound via the input module 150, or output the sound via the sound output module 155 or a headphone of an external electronic device (e.g., the external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment of the disclosure, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. According to an embodiment of the disclosure, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the external electronic device 102). According to an embodiment of the disclosure, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment of the disclosure, the haptic module 179 may include, for example, a motor, a piezoelectric element, or an electric stimulator.

The camera module 180 may capture a still image or moving images. According to an embodiment of the disclosure, the camera module 180 may include one or more lenses, image sensors, image signal processors, or flashes.

The power management module 188 may manage power supplied to the electronic device 101. According to one embodiment of the disclosure, the power management module 188 may be implemented as at least part of, for example, a power management integrated circuit (PMIC).

The battery 189 may supply power to at least one component of the electronic device 101. According to an embodiment of the disclosure, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment of the disclosure, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a fifth generation (5G) network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a fourth generation (4G) network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the millimeter wave (mmWave) band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the external electronic device 104), or a network system (e.g., the second network 199). According to an embodiment of the disclosure, the wireless communication module 192 may support a peak data rate (e.g., 20 gigabits per second (Gbps) or more) for implementing eMBB, loss coverage (e.g., 164dB or less) for implementing mMTC, or U-plane latency (e.g., 0.5 milliseconds (ms) or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment of the disclosure, the antenna module 197 may include an antenna including a radiating element including a conductive material or a conductive pattern formed in or on a substrate (e.g., a printed circuit board (PCB)). According to an embodiment of the disclosure, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment of the disclosure, another component (e.g., a radio frequency integrated circuit (RFIC)) other than the radiating element may be additionally formed as part of the antenna module 197.

According to various embodiments of the disclosure, the antenna module 197 may form a mmWave antenna module. According to an embodiment of the disclosure, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment of the disclosure, commands or data may be transmitted or received between the electronic device 101 and the external electronic device 104 via the server 108 coupled with the second network 199. Each of the external electronic devices 102 or 104 may be a device of a same type as, or a different type, from the electronic device 101. According to an embodiment of the disclosure, all or some of operations to be executed at the electronic device 101 may be executed at one or more of the external electronic devices 102or 104, or the server 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment of the disclosure, the external electronic device 104 may include an internet-of-things (IoT) device. The server 108 may be an intelligent server using machine learning and/or a neural network. According to an embodiment of the disclosure, the external electronic device 104 or the server 108 may be included in the second network 199. The electronic device 101 may be applied to intelligent services (e.g., a smart home, a smart city, a smart car, or healthcare) based on 5G communication technology or IoT-related technology.

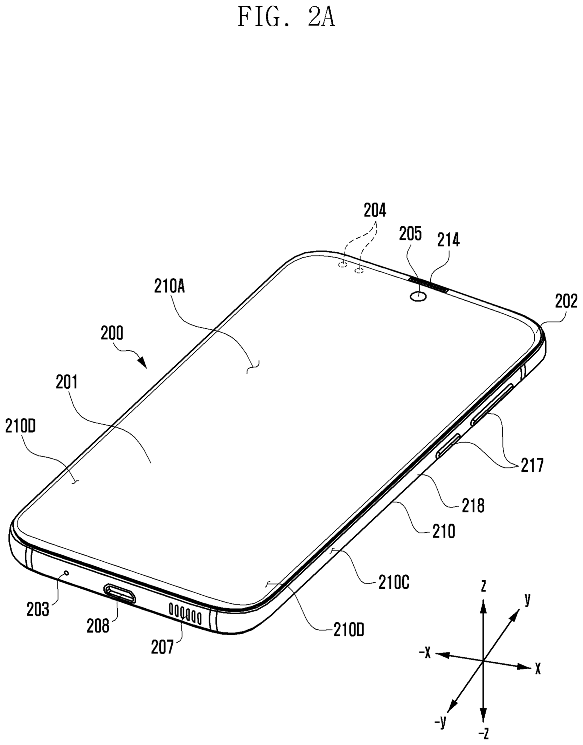

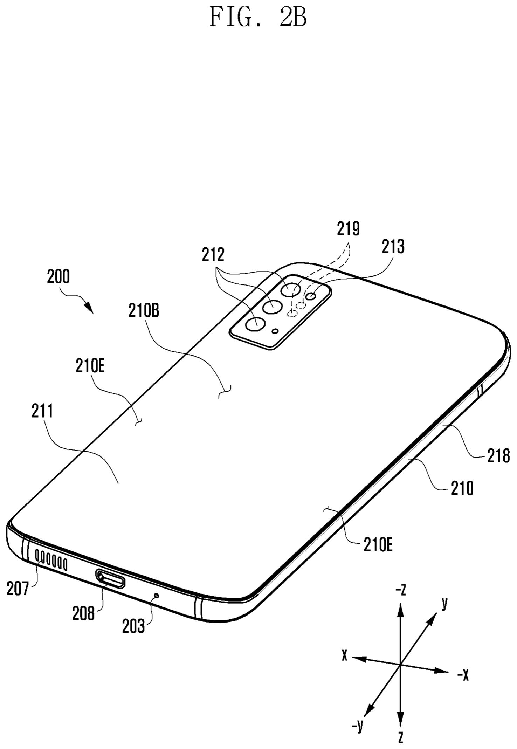

FIG. 2A is a perspective view of the front of an electronic device 200 according to an embodiment of the disclosure. FIG. 2B is a perspective view of the rear of the electronic device 200 in FIG. 2A according to an embodiment of the disclosure.

According to various embodiments of the disclosure, the electronic device 200 in FIGS. 2A and 2B may be at least partially similar to the electronic device 101 in FIG. 1 or may include other embodiments of the electronic device.

Referring to FIGS. 2A and 2B, an electronic device 200 according to an embodiment may include a housing 210 including a first surface (or front surface) 210A, a second surface (or rear surface) 210B, and a side surface 210C surrounding a space between the first surface 210A and the second surface 210B. In another embodiment (not shown), the housing 210 may indicate a structure constituting some of the first surface 210A, the second surface 210B, and the side surface 210C in FIGS. 2A and 2B. According to an embodiment of the disclosure, the first surface 210A may be formed by a front plate 202 (e.g., a glass plate or polymer plate including various coating layers) that is substantially transparent at least in part. The second surface 210B may be formed by a rear plate 211 that is substantially opaque. The rear plate 211 may be formed of, for example, coated or tinted glass, ceramic, polymer, metal (e.g., aluminum, stainless steel (STS), or magnesium), or a combination of at least two of the above materials. The side surface 210C may be formed by a side bezel structure (or "side member") 218 coupled to the front plate 202 and the rear plate 211 and including metal and/or polymer. In a certain embodiment of the disclosure, the rear plate 211 and the side bezel structure 218 may be integrally formed and include the same material (e.g., a metal material, such as aluminum).

In the illustrated embodiment of the disclosure, the front plate 202 may include a first area 210D that extends seamlessly to be curved from the first surface 210A toward the rear plate 211 at both ends of the long edge of the front plate 202. In the illustrated embodiment (e.g., see FIG. 2B), the rear plate 211 may include a second area 210E that extends seamlessly to be curved from the second surface 210B toward the front plate 202 at both ends of the long edge. In a certain embodiment of the disclosure, the front plate 202 or the rear plate 211 may include only one of the first area 210D or the second area 210E. In a certain embodiment of the disclosure, the front plate 202 may include only a flat plane disposed parallel to the second surface 210B, instead of include the first area 210D and the second area 210E. In the above embodiments of the disclosure, when viewed from the side of the electronic device 200, the side bezel structure 218 may have a first thickness (or width) on the side where the first area 210D or the second area 210E is not included, and may have a second thickness less than the first thickness on the side where the first area or the second area is included.

According to an embodiment of the disclosure, the electronic device 200 may include at least one or more of a display 201 (e.g., the display module 160 in FIG. 1), an input device 203 (e.g., the input module 150 in FIG. 1), audio output devices 207 and 214 (e.g., the sound output module 155 in FIG. 1), sensor modules 204 and 219 (e.g., the sensor module 176 in FIG. 1), camera modules 205, 212, and 213 (e.g., the camera module 180 in FIG. 1), a key input device 217, an indicator (not shown) (e.g., the interface 177 in FIG. 1), and a connector 208 (e.g., the terminal 178 in FIG. 1). In a certain embodiment of the disclosure, the electronic device 200 may exclude at least one (e.g., the key input device 217 or the indicator) of the elements or further include other elements in addition thereto.

The display 201 may be exposed, for example, through a substantial portion of the front plate 202. In a certain embodiment of the disclosure, at least a portion of the display 201 may be exposed through the front plate 202 that forms the first surface 210A and the first area 210D of the side surface 210C. The display 201 may be connected to or disposed adjacent to a touch detection circuit, a pressure sensor capable of measuring the intensity (pressure) of a touch, and/or a digitizer that detects a magnetic field-type stylus pen. In a certain embodiment of the disclosure, at least a part of the sensor modules 204 and 219 and/or at least a part of the key input device 217 may be disposed in the first area 210D and/or the second area 210E.

The input device 203 may include a microphone 203. In a certain embodiment of the disclosure, the input device 203 may include a plurality of microphones 203 arranged to detect the direction of sound. The audio output devices 207 and 214 may include speakers 207 and 214. The speakers 207 and 214 may include an external speaker 207 and a receiver for calls. In a certain embodiment of the disclosure, the microphone 203, speakers 207 and 214, and connector 208 may be disposed in the space of the electronic device 200 and may be exposed to the external environment through at least one hole formed on the housing 210. In a certain embodiment of the disclosure, the hole formed in the housing 210 may be commonly used for the microphone 203 and the speakers 207 and 214. In a certain embodiment of the disclosure, the audio output devices 207 and 214 may include a speaker (e.g., a piezo speaker) that operates without the hole formed on the housing 210.

The sensor modules 204 and 219 may generate electrical signals or data values corresponding to an internal operation state of the electronic device 200 or an external environmental state. The sensor modules 204 and 219 may include, for example, a first sensor module (e.g., a proximity sensor) and/or a second sensor module (not shown) (e.g., a fingerprint sensor) disposed on the first surface 210A of housing 210, and/or a third sensor module 219 (e.g., an heart rate monitor (HRM) sensor) disposed on the second surface 210B of the housing 210. The fingerprint sensor may be disposed on the first surface 210A of the housing 210. A fingerprint sensor (e.g., an ultrasonic or optical fingerprint sensor) may be disposed under the display 201 on the first surface 210A. The electronic device 200 may further include a sensor module that is not shown, for example, at least one of a gesture sensor, a gyro sensor, an atmosphere pressure sensor, a magnetic sensor, an acceleration sensor, a grip sensor, a color sensor, an infrared (IR) sensor, a biometric sensor, a temperature sensor, a humidity sensor, and an illuminance sensor.

The camera modules 205, 212, and 213 may include a first camera device disposed on the first surface 210A of the electronic device 200, and a second camera device 212 and/or a flash 213 disposed on the second surface 210B. The camera modules 205 and 212 may include one or more lenses, an image sensor, and/or an image signal processor. The flash 213 may include, for example, a light-emitting diode or a xenon lamp. In a certain embodiment of the disclosure, two or more lenses (e.g., wide-angle and telephoto lenses) and image sensors may be disposed on one surface of the electronic device 200.

The key input device 217 may be disposed on the side surface 210C of the housing 210. In another embodiment of the disclosure, the electronic device 200 may exclude some or all of the key input devices 217 mentioned above, and the excluded key input devices 217 may be implemented in other forms, such as soft keys on the display 201. In another embodiment of the disclosure, the key input device 217 may be implemented using a pressure sensor included in the display 201.

An indicator (not shown) may be disposed, for example, on the first surface 210A of the housing 210. For example, the indicator may provide state information of the electronic device 200 in the form of light. In another embodiment of the disclosure, the light-emitting device may provide, for example, a light source linked to the operation of the camera module 205. The indicator may include, for example, light-emitting diodes (LEDs), IR LEDs, and xenon lamps.

The connector hole 208 may include a connector hole capable of receiving a connector (e.g., a USB connector or an interface connector port module (IF module) for transmitting and receiving power and/or data to and from an external electronic device, and/or a connector hole (or earphone jack) capable of receiving a connector for transmitting and receiving audio signals to and from an external electronic device.

Some camera modules 205 among the camera modules 205 and 212, some sensor modules 204 among the sensor modules 204 and 219, or the indicator may be disposed to be exposed through the display 201. For example, the camera module 205, the sensor module 204, or the indicator may be disposed in the inner space of the electronic device 200 so as to communicate with the external environment through an opening perforated to the front plate 202 of the display 201 or a transparent area. According to an embodiment of the disclosure, the area where the display 201 and the camera module 205 face each other is a portion of the area displaying content, which may be configured as a transmission area with a predetermined transmittance. According to an embodiment of the disclosure, the transmission area may be formed to have a transmittance in the range of about 5% to 20%. This transmission area may include an area overlapping the effective area (e.g., the field of view) of the camera module 205 through which light is incident on the image sensor to produce an image. For example, the transmission area of the display 201 may include an area having a lower pixel density than the surrounding areas. For example, the transmission area may replace the opening. For example, the camera module 205 may include an under-display camera (UDC). In another embodiment of the disclosure, some sensor modules 204 may be disposed in the inner space of the electronic device 200 so as to perform their functions without being visually exposed through the front plate 202. For example, in this case, the area of display 201 facing the sensor module may not require a perforated opening.

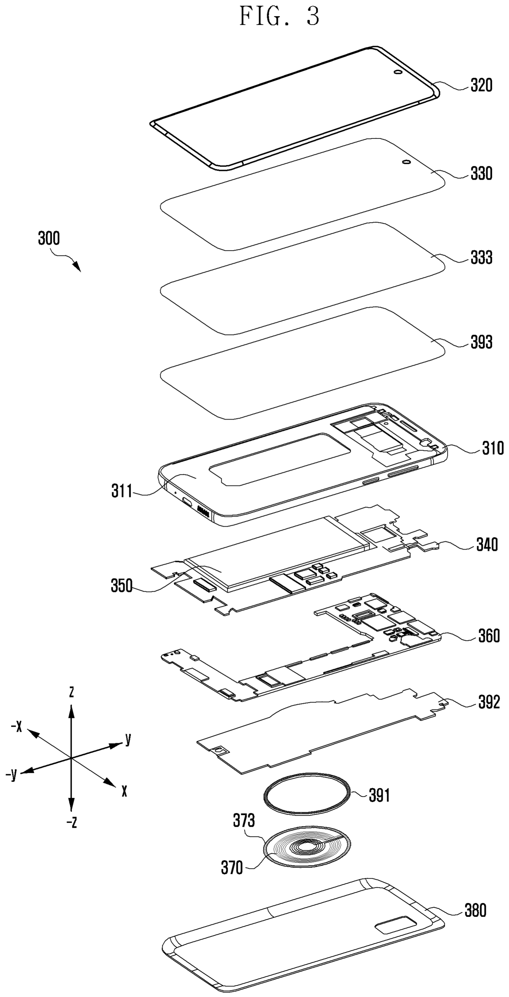

FIG. 3 is an exploded perspective view of an electronic device according to an embodiment of the disclosure.

According to various embodiments of the disclosure, an electronic device 300 in FIG. 3 may be at least partially similar to the electronic device 101 in FIG. 1 or the electronic device 200 in FIGS. 2A and 2B, or may include other embodiments of the electronic device.

Referring to FIG. 3, the electronic device 300 may include a side member 310 (e.g., a side bezel structure), a first support member 311 (e.g., a bracket or support structure), and a front plate 320 (e.g., a front cover), a display 330, a printed circuit board 340, a battery 350, a second support member 360 (e.g., a rear case), a coil 370, and a rear plate 380 (e.g., a rear cover). In a certain embodiment of the disclosure, the electronic device 300 may exclude at least one (e.g., the first support member 311 or the second support member 360) of the elements or may further include other elements. At least one of the elements of the electronic device 300 may be the same as or similar to at least one of the elements of the electronic device 200 in FIGS. 2A and 2B, and redundant descriptions thereof will be omitted below.

The first support member 311 may be disposed inside the electronic device 300 and connected to the side member 310 or formed integrally with the side member 310. The first support member 311 may be formed of, for example, a metal material and/or a non-metal (e.g., polymer) material. The first support member 311 may have one side to which the display 330 is coupled and the other side to which the printed circuit board 340 is coupled. A touch detection circuit, a pressure sensor capable of measuring the intensity (pressure) of touch, and/or a digitizer 333 that detects a magnetic field-type stylus pen may be coupled to the display 330 or disposed to face or adjacent to the same. The printed circuit board 340 may include a processor (e.g., the processor 120 in FIG. 1), memory (e.g., the memory 130 in FIG. 1), and/or an interface (e.g., the interface 177 in FIG. 1) mounted thereon.

The processor may include, for example, one or more of a central processing unit, an application processor, a graphics processing unit, an image signal processor, a sensor hub processor, or a communication processor.

The memory may include, for example, volatile memory (e.g., the volatile memory 132 in FIG. 1) or non-volatile memory (e.g., the non-volatile memory 134 in FIG. 1).

The interface may include, for example, a high-definition multimedia interface (HDMI), a universal serial bus (USB) interface, an SD card interface, and/or an audio interface. For example, the interface may electrically or physically connect the electronic device 300 to an external electronic device and may include a USB connector, an SD card/ multimedia card (MMC) connector, or an audio connector.

The battery 350 (e.g., the battery 189 in FIG. 1) is a device for supplying power to at least one element of electronic device 300 and may include, for example, a non-rechargeable primary battery, a rechargeable secondary battery, or a fuel cell. At least a portion of the battery 350 may be disposed, for example, substantially on the same plane as the printed circuit board 340. The battery 350 may be disposed integrally inside the electronic device 300. In another embodiment of the disclosure, the battery 350 may be disposed to be detachable from the electronic device 300.

The electronic device 300 may include a coil 370 wound in a circle. For example, the coil 370 may be located between the rear plate 380 and the second support member 360 (for example, attached to the rear plate 380). The coil 370 may include a magnetic secure transmission (MST) antenna, a near-field communication (NFC) antenna, and/or a wireless charging antenna. For example, the coil 370 may perform short-range communication with an external electronic device or wirelessly transmit and receive power required for charging. In another embodiment of the disclosure, a part of the side bezel structure 310 and/or the first support member 311 or a combination thereof may form an antenna structure.

In various embodiments of the disclosure, the electronic device 300 may include a magnet assembly 373 including a plurality of magnets disposed adjacent to the coil 370. For example, the magnet assembly 373 may be disposed adjacent to the outermost coil of the coil 370 so as to surround the outermost coil.

In various embodiments of the disclosure, the electronic device 300 may include a first shielding sheet 391 to shield a magnetic field generated from the magnet assembly 373 toward the inside of the electronic device 300. For example, the first shielding sheet 391 may be attached to the magnet assembly 373. For example, the first shielding sheet 391 may have an area that is substantially identical to the area of the magnet assembly 373 including a plurality of magnets.

According to various embodiments of the disclosure, the first shielding sheet 391 may include a soft magnetic material with a high saturation magnetic flux density (Bs) and/or a high magnetic permeability. The soft magnetic material may include, for example, a magnetic material with shielding characteristics, such as a high saturation magnetic flux density of 2.0T (tesla) or more and a relative magnetic permeability of about 2000 or more. The soft magnetic material capable of being used for the first shielding sheet 391 may include, for example, materials, such as soft magnetic ferrite or nickel/iron/cobalt alloy materials used for magnetic field shielding. For example, the soft magnetic material may include steel plate cold commercial (SPCC), permalloy, stainless steel plates (e.g., SUS430, SUS304, or SUS630), carbon steel plates (e.g., S45C), and/or Mu-metal. For example, the SPCC may have a saturation magnetic flux density (Bs) of about 2.0T and a magnetic permeability of about 2475.

In various embodiments of the disclosure, the second shielding sheet 392 may be disposed at a position opposing to the coil 370 and the first shielding sheet 391. For example, the second shielding sheet 392 may shield the magnetic field generated from the coil 370 and/or the magnet assembly 373 toward the inside of the electronic device 300.

According to various embodiments of the disclosure, the second shielding sheet 392 may be made of a shielding material having low electrical conductivity to prevent eddy current and having a heat dissipation effect based on the charging performance of the coil 370. The second shielding sheet 392 may include a soft magnetic material with a saturation magnetic flux density (Bs) and/or a magnetic permeability, which are slightly lower than the first shielding sheet 391. The soft magnetic material capable of being used as the second shielding sheet 392 may include, for example, nano-crystiline with shielding characteristics, such as a saturation magnetic flux density of about 1.2T and a magnetic permeability of about 2100. The soft magnetic material capable of being used as the second shielding sheet 392 may include, for example, materials, such as soft magnetic ferrite or nickel/iron/cobalt alloy materials used for magnetic field shielding.

In various embodiments of the disclosure, a third shielding sheet 393 may be disposed between the display 330 and the second shielding sheet 392. For example, the third shielding sheet 393 may be disposed between the digitizer 333 and the second shielding sheet 392. For example, the third shielding sheet 393 may be attached to the back side of the digitizer 333 (e.g., on the side facing the inside of the electronic device). For example, the third shielding sheet 393 may shield the magnetic field generated from the coil 370 and the magnet assembly 373 toward the display 330 or the digitizer 333.

According to an embodiment of the disclosure, the digitizer 333 may include, for example, a flexible printed circuit board, a magnetic layer including a sandust magnetic material or a magnetic metal powder (MMP) material, and/or a metal layer including metal, such as Cu or Al.

According to an embodiment of the disclosure, the third shielding sheet 393 attached to the back side of the digitizer 333 (e.g., on the side facing the inside of the electronic device) may shield the magnetic field that is generated by the magnet assembly 373 and affects the performance of the digitizer 333.

According to various embodiments of the disclosure, the third shielding sheet 393 may be made of a shielding material capable of preventing eddy current induced in the digitizer 333 and having a heat dissipation effect. The third shielding sheet 393 may include a soft magnetic material with a saturation magnetic flux density (Bs) and/or a magnetic permeability, which are slightly lower than the first shielding sheet 391. The soft magnetic material capable of being used as the third shielding sheet 393 may include, for example, nano-crystiline with shielding characteristics, such as a saturation magnetic flux density of about 1.6T and a magnetic permeability of about 1500. The soft magnetic material capable of being used as the third shielding sheet 393 may include, for example, materials, such as soft magnetic ferrite or nickel/iron/cobalt alloy materials used for magnetic field shielding.

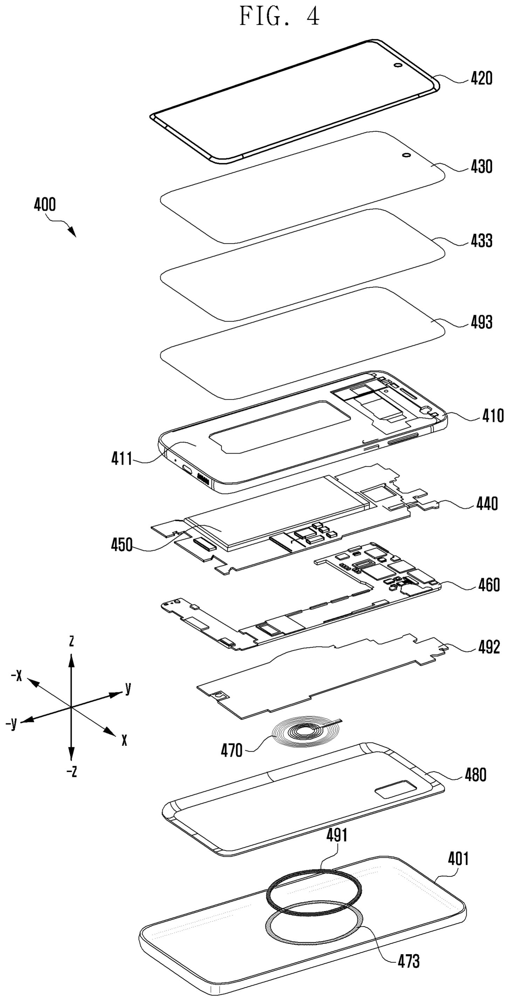

FIG. 4 is an exploded perspective view of an electronic device 400 and a case device 401 according to an embodiment of the disclosure.

According to various embodiments of the disclosure, the electronic device 400 in FIG. 4 may be at least partially similar to the electronic device 101 in FIG. 1 or the electronic device 200 in FIGS. 2A and 2B, or may include other embodiments of the electronic device.

At least one of the elements of the electronic device 400 may be the same as or similar to at least one of the elements of the electronic device 300 in FIG. 3, and redundant descriptions thereof will be omitted below.

Referring to FIG. 4, the electronic device 400 may include a side member 410 (e.g., a side bezel structure), a first support member 411 (e.g., a bracket or support structure), a front plate 420 (e.g., a front cover), a display 430, a printed circuit board 440, a battery 450, a second support member 460 (e.g., a rear case), a coil 470, and a rear plate 480 (e.g., a rear cover). In a certain embodiment of the disclosure, the electronic device 400 may exclude at least one (e.g., the first support member 411 or the second support member 460) of the elements or may further include other elements.

The first support member 411 may be disposed inside the electronic device 400 and connected to the side member 410 or formed integrally with the side member 410.

The electronic device 400 may include a coil 470 wound in a circle. For example, the coil 470 may be located between the rear plate 480 and the second support member 460 (for example, attached to the rear plate 480). The coil 470 may include a magnetic secure transmission (MST) antenna, a near-field communication (NFC) antenna, and/or a wireless charging antenna. For example, the coil 470 may perform short-range communication with an external electronic device or wirelessly transmit and receive power required for charging. In another embodiment of the disclosure, a part of the side bezel structure 410 and/or the first support member 411 or a combination thereof may form an antenna structure.

Referring to FIG. 4, the case device 401 may be configured in a form that surrounds at least a portion of at least one surface of the electronic device when it is mounted to the electronic device 400.

According to various embodiments of the disclosure, the case device 401 may include a magnet assembly 473 including a plurality of magnets disposed to be positioned adjacent to the coil 470 of the electronic device 400 when it is mounted to the electronic device 400. For example, the magnet assembly 473 may have the same or similar shape and structure as the magnet assembly 373 of the electronic device 300 described with reference to FIG. 3. For example, the magnet assembly 473 may be implemented to be disposed adjacent to the outermost coil of the coil 470 and surround the outermost coil in the state in which the case device 401 is mounted to the electronic device 400.

In various embodiments of the disclosure, the case device 401 may include a first shielding sheet 491 to shield the magnetic field generated from the magnet assembly 473 toward the inside of the electronic device 400. For example, the first shielding sheet 491 may have an area that is substantially identical to the area of the magnet assembly 473 including a plurality of magnets. For example, the first shielding sheet 491 may be attached to the magnet assembly 473.

According to various embodiments of the disclosure, the first shielding sheet 491 may include a soft magnetic material with a high saturation magnetic flux density (Bs) and/or a high magnetic permeability. The soft magnetic material capable of being used as the first shielding sheet 491 of the case device 401 has been described when describing the first shielding sheet 391 of the electronic device 300 in FIG. 3, so a detailed description thereof will be omitted.

In various embodiments of the disclosure, a second shielding sheet 492 may be disposed inside the electronic device 400 at a position opposing to the coil 470 of the electronic device 400 and the first shielding sheet 491 of the case device 401. For example, the second shielding sheet 492 may shield the magnetic field generated from the coil 470 and/or the magnet assembly 473 toward the inside of the electronic device 400.

According to various embodiments of the disclosure, the second shielding sheet 492 may be made of a shielding material having low electrical conductivity to prevent eddy current and having a heat dissipation effect based on the charging performance of the coil 470. The second shielding sheet 492 may include a soft magnetic material with a saturation magnetic flux density (Bs) and/or a magnetic permeability, which are slightly lower than the first shielding sheet 491. The soft magnetic material capable of being used as the second shielding sheet 492 has been described when describing the second shielding sheet 492 of the electronic device 300 in FIG. 3, so a detailed description thereof will be omitted.

In various embodiments of the disclosure, a third shielding sheet 493 may be disposed between the display 430 and the second shielding sheet 492. For example, the third shielding sheet 493 may be disposed between a digitizer 433 and the second shielding sheet 492. For example, the third shielding sheet 493 may be attached to the back side (e.g., on the side facing the inside of the electronic device) of the digitizer 433. For example, the third shielding sheet 493 may shield the magnetic field generated from the coil 470 and the magnet assembly 473 toward the display 430 or the digitizer 433.

According to various embodiments of the disclosure, the third shielding sheet 493 may be made of a shielding material capable of preventing eddy current induced in the digitizer 433 and having a heat dissipation effect. The third shielding sheet 493 may include a soft magnetic material with a saturation magnetic flux density (Bs) and/or a magnetic permeability, which are slightly lower than the first shielding sheet 491. The soft magnetic material capable of being used as the third shielding sheet 493 has been described when describing the third shielding sheet 493 in FIG. 3, so a detailed description thereof will be omitted.

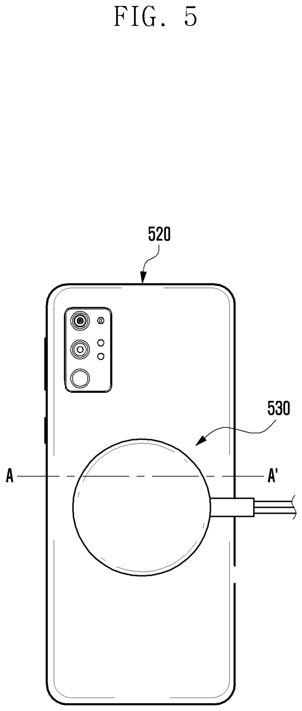

FIG. 5 is a diagram schematically illustrating an operation in which a power transmission device 530 charges a power reception device 520 according to an embodiment of the disclosure.

Referring to FIG. 5, the power transmission device 530 may charge the power reception device 520 by wirelessly transmitting power. For example, if a battery (e.g., the battery 189 in FIG. 1) of the power reception device 520 is discharged or if the amount of available power is below a specified level, the power transmission device 530 may transmit power wirelessly to charge the battery 189 of the power reception device 520.

In various embodiments of the disclosure, the power reception device 520 in FIG. 5 may include the electronic device 101 disclosed in FIG. 1 (or the electronic device 200 in FIGS. 2A and 2B, the electronic device 300 in FIG. 3, or the electronic device 400 equipped with the case device 401 in FIG. 4). For example, the power reception device 520 may include at least one of a smartphone, a wearable device (e.g., a watch), or a tablet. The power transmission device 530 may be the same as or similar to the power reception device 520. For example, the power transmission device 530 may include a wireless charging pad, a tablet, or a smartphone. The power transmission device 530 may be implemented by at least one of the electronic devices 101, the external electronic devices 102, and/or 104 disclosed in FIG. 1. The power transmission device 530 may include at least one of the elements of the electronic device 101 shown in FIG. 1.

In various embodiments of the disclosure, the power transmission device 530 may have a circular housing, but is not limited thereto, and the power transmission device 530 may have a square, rectangular, or oval housing. The power transmission device 530 may include a coil disposed in the inner space of the housing of the power transmission device 530. The power transmission device 530 may include a magnet assembly disposed adjacent to the outermost coil of the coil and including a plurality of magnets disposed to be spaced apart from the outermost coil.

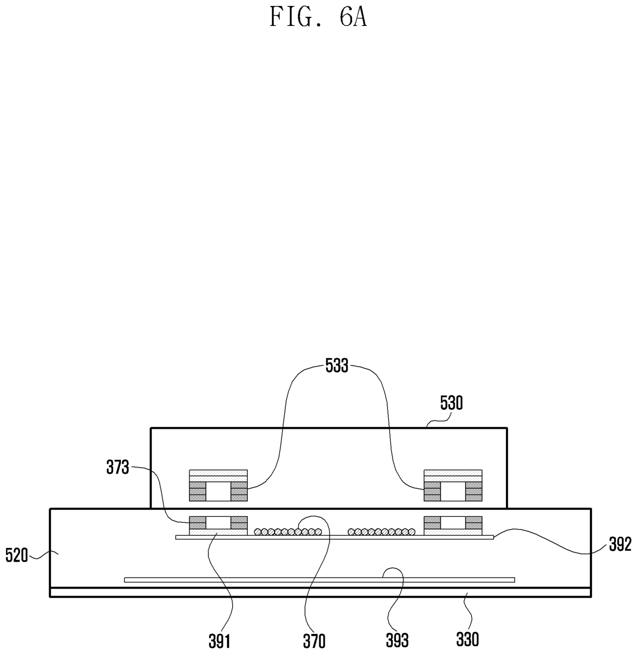

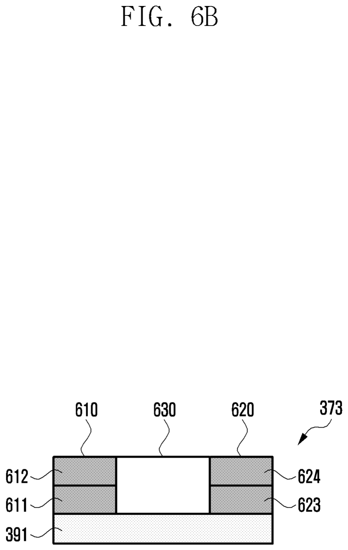

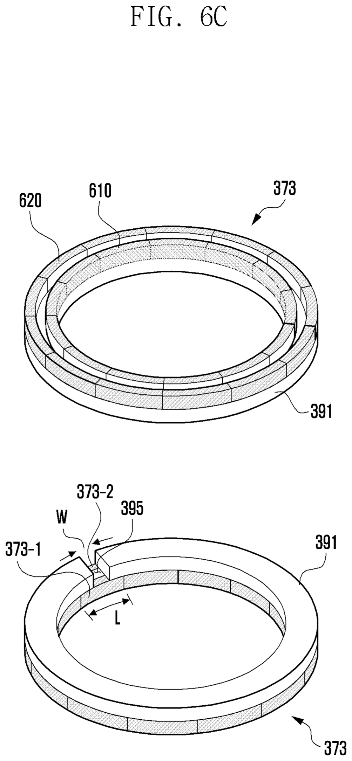

FIGS. 6A, 6B, and 6C are diagrams illustrating a coil 370 or 470 and a magnet assembly 373 or 473 disposed in the inner space of a power reception device (e.g., the power reception device 520 in FIG. 5) according to various embodiments of the disclosure.

Referring to FIGS. 6A, 6B, and 6C, the power reception device (e.g., the power reception device 520 in FIG. 5) may wirelessly receive power from the power transmission device (e.g., the power transmission device 530 in FIG. 5) while being is contact with the power transmission device 530. The power reception device 520 in FIG. 5 may include the electronic device 101 disclosed in FIG. 1 (or the electronic device 200 in FIGS. 2A and 2B, the electronic device 300 in FIG. 3, or the electronic device 400 equipped with the case device 401 in FIG. 4). Hereinafter, although the power reception device 520 in FIG. 5 will be described based on the electronic device 300 in FIG. 3 as an example, it may also be applied to the electronic device 400 equipped with the case device 401 in FIG. 4.

In an embodiment of the disclosure, the electronic device 300 may include a magnet assembly (e.g., the magnet assembly 373 in FIG. 3) including a plurality of magnets configured to surround the coil (e.g., the coil 370 in FIG. 3) wound in a circle. For example, the plurality of magnets in the magnet assembly 373 may be disposed adjacent to the outermost coil of the coil 370 and to be spaced apart from the outermost coil to surround the outermost coil. For example, the magnet assembly 373 of the power reception device 300 may be implemented in a closed loop. In an embodiment of the disclosure, the magnet assembly 373 may be implemented substantially in an arch shape and may include a plurality of magnets each having a rectangular or trapezoidal shape.

FIG. 6A illustrates a cross-sectional view taken along line A-A' in FIG. 5 and shows the state in which, when the power reception device 520 is in contact with (or attached to) the power transmission device 530, the magnet assembly 373 including a plurality of magnets of the power reception device 520 is coupled to the magnet assembly 533 including a plurality of magnets of the power transmission device 530, so that the coil (e.g., the coil 370 in FIG. 3) of the power reception device 520 and the coil (not shown) of the power transmission device 530 are disposed in alignment.

According to an embodiment of the disclosure, the plurality of magnets of the magnet assembly 373 of the power reception device 520 that comes into contact with (or is attached to) the opposite power transmission device 530 may be magnetized in the polarities opposite those of the magnets included in the magnet assembly 533 of the power transmission device 530.

According to an embodiment of the disclosure, the power reception device 520 may include a first shielding sheet 391 disposed to shield the magnetic field generated from the magnet assembly 533 of the power transmission device 530, as well as from the magnet assembly 373 of the power reception device 520.

In an embodiment of the disclosure, the power reception device 520 may include a second shielding sheet 392 disposed at a position opposing to the coil 370 and the first shielding sheet 391 to shield the magnetic field generated from the coil 370 and/or the magnet assembly 373 toward the inside of the power reception device 520.

According to an embodiment of the disclosure, the distance between the magnet assembly 373 or 473 or the first shielding sheet 391 or 491 and the second shielding sheet 392 or 492 may vary depending on experimental values, and may be implemented to be longer in the case where the magnet assembly 473 and the first shielding sheet 491 are disposed in the case device 401, compared to the case where the magnet assembly 373 and the first shielding sheet 391 are disposed in the electronic device 300.

In various embodiments of the disclosure, a third shielding sheet 393 may be further disposed between the display 330 and the second shielding sheet 392 to shield the magnetic field generated from the coil 370 and/or the magnet assembly 373 toward the inside of the power reception device 520. For example, the third shielding sheet 393 may shield the magnetic field generated from the coil 370 and the magnet assembly 373 toward the display 330 or the digitizer 333.

Referring to FIG. 6B, the magnet assembly 373 of the power reception device 520 may include a plurality of first magnets 610 disposed to surround the coil 370, and a plurality of second magnets 620 disposed at a designated distance from the plurality of first magnets 610 so as to surround the plurality of first magnets 610. For example, the designated distance between the plurality of first magnets 610 and the plurality of second magnets 620 may form an opening 630.

According to an embodiment of the disclosure, the plurality of first magnets 610 may include a first layer 611 and a second layer 612, which is an upper layer of the first layer 611, and the plurality of second magnets 620 may include a third layer 623 and a fourth layer 624 that is an upper layer of the third layer 623. The plurality of first magnets 610 and the plurality of second magnets 620 may be magnetized in vertically opposite directions, and the first layer 611 and the fourth layer 624 may have a first polarity, and the second layer 612 and the third layer 623 may have a second polarity opposite the first polarity.

According to an embodiment of the disclosure, a first shielding sheet 391 may be attached to an area substantially identical to the area of the magnet assembly 373 formed by the plurality of first magnets 610 and the plurality of second magnets 620

Referring to FIG. 6C, the first shielding sheet 391 may be attached to an area substantially identical to the area of the magnet assembly 373 including the plurality of magnets.

According to an embodiment of the disclosure, at least a part of the first shielding sheet 391 may include a specific area 395 in which a soft magnetic material, which is a constituent material of the first shielding sheet, is not disposed. For example, the specific area 395 may not shield the magnetic field generated toward the inside of the electronic device 300. For example, the specific area may be defined by not disposing the soft magnetic material constituting the first shielding sheet in at least a part of the first shielding sheet 391. For example, a plurality of specific areas may be disposed in a plurality of areas of the first shielding sheet 391.

According to an embodiment of the disclosure, the width W of at least one specific area 395 disposed on the first shielding sheet 391 may be less than the length L of one of the first magnet 373-1 and/or the second magnet 373-2 of the plurality of first magnets 610 and the plurality of second magnets 620.

According to an embodiment of the disclosure, at least one specific area 395 disposed on the first shielding sheet 391 may be disposed at a position opposing to the one first magnet 373-1 and second magnet 373-2.

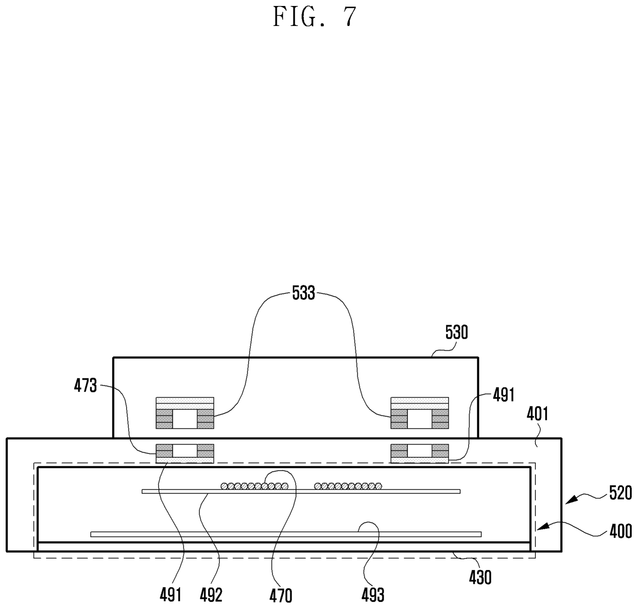

FIG. 7 is a diagram illustrating a coil 470 disposed in an inner space of a power reception device (e.g., the power reception device 520 in FIG. 5) and a magnet assembly 473 disposed in an inner space of a case device (e.g., case device 401 in FIG. 4) according to an embodiment of the disclosure.

Referring to FIG. 7, the power reception device (e.g., the power reception device 520 in FIG. 5) may wirelessly receive power from the power transmission device (e.g., the power transmission device 530 in FIG. 5) while being is contact with the power transmission device 530. The power reception device 520 in FIG. 5 may include the electronic device 400 equipped with the case device 401 in FIG. 4. Hereinafter, the power reception device 520 in FIG. 5 will be described based on the electronic device 400 and the case device 401 in FIG. 4.

In an embodiment of the disclosure, the electronic device 400 may include a coil (e.g., the coil 470 in FIG. 4) wound in a circle, and the case device 401 may include a magnet assembly (e.g., the magnet assembly 473 in FIG. 4) including a plurality of magnets configured to surround the coil 470. For example, the plurality of magnets of the magnet assembly 473 may be disposed adjacent to the outermost coil of the coil 470 and to be spaced apart from the outermost coil to surround the outermost coil. For example, the magnet assembly 473 of the case device 401 may be implemented in a closed loop. In an embodiment of the disclosure, the magnet assembly 473 may include a plurality of magnets each having substantially a rectangular or trapezoidal shape.

FIG. 7 illustrates a cross-sectional view taken along line A-A' in FIG. 5 and shows the state in which, when the power reception device 520 to which the case device 401 is mounted is in contact with (or attached to) the power transmission device 530, the magnet assembly 473 including a plurality of magnets of the case device 401 is coupled to the magnet assembly including a plurality of magnets of the power transmission device 530, so that the coil (e.g., the coil 470 in FIG. 4) of the power reception device 520 and the coil (not shown) of the power transmission device 530 are disposed in alignment.

According to an embodiment of the disclosure, the plurality of magnets of the magnet assembly 473 of the case device 401 that comes into contact with (or is attached to) the opposite power transmission device 530 may be magnetized in the polarities opposite those of the magnets included in the magnet assembly of the power transmission device 530.

According to an embodiment of the disclosure, the case device 401 may include a first shielding sheet 491 disposed to shield the magnetic field generated from the magnet assembly 473 of the case device 401 and/or the magnet assembly 533 of the power transmission device 530.

In an embodiment of the disclosure, the power reception device 520 may include a second shielding sheet 492 disposed at a position opposing to the coil 470 and the first shielding sheet 491 of the case device 401 to shield the magnetic field generated from the coil 470 and/or the magnet assembly 473 toward the inside of the power reception device 520.

In various embodiments of the disclosure, a third shielding sheet 493 may be further disposed between the display 430 and the second shielding sheet 492 of the power reception device 520 to shield the magnetic field generated from the coil 470 and/or the magnet assembly 473 toward the inside of the power reception device 520. For example, the third shielding sheet 493 may shield the magnetic field generated from the coil 470 and the magnet assembly 473 toward the display 430 or the digitizer 433.

The configuration of the magnet assembly 473 and the first shielding sheet 491 of the case device 401 in FIG. 7 is the same as or similar to that of the magnet assembly 373 and the first shielding sheet 491 of the electronic device 300 described with reference to FIGS. 6A, 6B, and 6C, so a detailed description thereof will be omitted here.

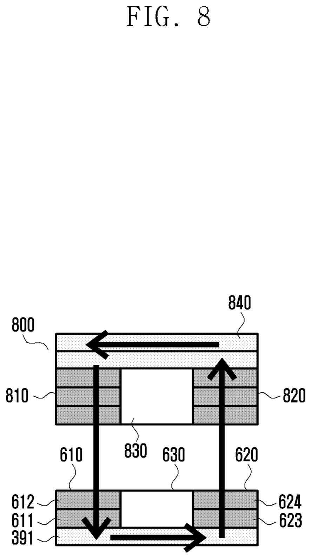

FIG. 8 is a cross-sectional view of magnet assemblies of a power transmission device (e.g., the power transmission device 530 in FIG. 5) and a power reception device (e.g., the power reception device 520 in FIG. 5) according to an embodiment of the disclosure, which illustrates the directions of magnetic force lines formed inside the magnet assemblies.

Referring to FIG. 8, a magnet assembly (e.g., the magnet assembly 373 or 473 in FIG. 3 or 4) of the power reception device (e.g., the power reception device 520 in FIG. 5) may be coupled to a magnet assembly 800 of the power transmission device (e.g., the power transmission device 530 in FIG. 5), so that a coil (e.g., the coil 370 or 470 in FIG. 3 or 4) of the power reception device 520 and the coil (not shown) of the power transmission device 530 are disposed in alignment for power transmission and reception. The power reception device 520 may include the electronic device 101 disclosed in FIG. 1 (or the electronic device 200 in FIGS. 2A and 2B, the electronic device 300 in FIG. 3, or the electronic device 400 equipped with the case device 401 in FIG. 4). Hereinafter, although the power reception device 520 in FIG. 5 will be described based on the electronic device 300 in FIG. 3 as an example, it may also be applied to the electronic device 400 equipped with the case device 401 in FIG. 4.

According to an embodiment of the disclosure, a plurality of magnets of the magnet assembly 373 or 473 of the power reception device 520 that comes into contact with (or is attached to) the opposite power transmission device 530 may be magnetized in the polarities opposite those of magnets included in the magnet assembly 800 of the power transmission device 530.

According to an embodiment of the disclosure, the power reception device 520 may include a first shielding sheet 391 or 491 disposed to shield the magnetic field generated from the magnet assembly 800 of the power transmission device 530, as well as from the magnet assembly 373 or 473 of the power reception device 520.

According to an embodiment of the disclosure, the first shielding sheet 391 or 491 may be attached to an area substantially identical to the area of the magnet assembly 373 or 473 formed by the plurality of first magnets 610 or the plurality of second magnets 620.

According to an embodiment of the disclosure, the magnet assembly 373 or 473 of the power reception device 520 may include a plurality of first magnets 610 disposed to surround the coil 370 or 470, and a plurality of second magnets 620 disposed at a designated distance from the plurality of first magnets 610 so as to surround the plurality of first magnets 610. For example, the designated distance between the plurality of first magnets 610 and the plurality of second magnets 620 may form an opening 630. For example, the opening 630 may be formed as an empty space. For example, the opening 630 may be filled with a non-magnetic material. For example, the opening 630 may be filled with a material that is the same as the plurality of first magnets 610 and/or the plurality of second magnets 620 but is not magnetized to have no polarity.

According to an embodiment of the disclosure, the plurality of first magnets 610 may include a first layer 611 and a second layer 612, which is an upper layer of the first layer 611, and the plurality of second magnets 620 may include a third layer 623 and a fourth layer 624 that is an upper layer of the third layer 623. The plurality of first magnets 610 and the plurality of second magnets 620 may be magnetized in vertically opposite directions, and the first layer 611 and the fourth layer 624 may have a first polarity, and the second layer 612 and the third layer 623 may have a second polarity opposite the first polarity.

According to an embodiment of the disclosure, the magnet assembly 800 of the power transmission device 530 may include a plurality of first magnets 810 corresponding to the plurality of first magnets 610 of the power reception device 520, and a plurality of second magnets 820 corresponding to the plurality of second magnets 620 of the power reception device 520. The plurality of second magnets 820 may be disposed to be spaced a designated distance apart from the plurality of first magnets 810. The designated distance between the plurality of first magnets 810 and the plurality of second magnets 820 may form an opening 830. The opening 630 formed by the designated distance between the plurality of first magnets 610 and the plurality of second magnets 620 of the power reception device 520 may be implemented to identical to the area of the opening 830 formed by the designated distance between the plurality of first magnets 810 and the plurality of second magnets 820 of the power transmission device 530. A shielding sheet 840 may be attached to the magnet assembly 800 of the power transmission device 530.

According to an embodiment of the disclosure, if the power transmission device 530 including the corresponding magnet assembly 800 approaches, the magnet assembly 373 or 473 of the power reception device 520 may produce a closed loop of magnetic flux that starts from the plurality of first magnets 610 of the magnet assembly 373 or 473 and returns back to the plurality of first magnets 610 of the power reception device 520 via the first shielding sheet 391 or 491, the plurality of second magnets 620, and then the magnet assembly 800 of the power transmission device 530.

According to an embodiment of the disclosure, the opening 630 formed in the magnet assembly 373 or 473 of the power reception device 520 may cause the first magnet 610 and the second magnet 620 to form magnetic paths in the vertical direction, and the shielding sheet 391 or 491 may form a magnetic path in the horizontal direction, thereby forming a closed loop within the magnet assembly 373 or 473 to prevent magnetic flux from leaking to the outside.

According to an embodiment of the disclosure, since the opening 630 formed in the magnet assembly 373 or 473 of the power reception device 520 is configured to correspond, in position and/or area, to the opening 830 formed in the magnet assembly 800 of the power transmission device 530, the closed loop of magnetic flux may be more appropriately formed, thereby further reducing the influence of the magnetic field on the digitizer 333 or 433.

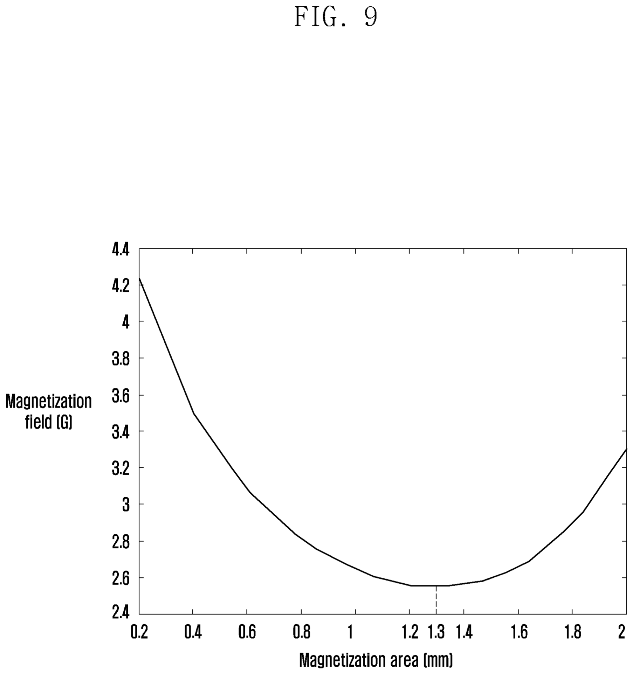

FIG. 9 is a diagram illustrating comparison of changes in magnetic-field affecting a digitizer 333 or 433 depending on the width of a magnetization area of a magnet assembly (e.g., the magnet assembly 373 or 473 in FIG. 3 or 4) according to an embodiment of the disclosure.

Referring to FIG. 9, the horizontal axis of the graph represents the magnetization area of the magnet assembly 373 or 473 of the power reception device 520, for example, the area having the polarities of the plurality of first magnets 610 and the plurality of second magnets 620, which shows that the width of the magnetization area increases and the area of the opening 630 is reduced as the value increases to the right on the horizontal axis. In addition, the vertical axis of the graph may represent the maximum magnetic field or magnetic flux density (G) at which the magnetic field generated by the magnet assembly 373 or 473 exerts on the digitizer surface.

Referring to FIG. 9, when the area of the opening 630 is relatively large (in the left part of the graph), the maximum magnetic field (G) applied to the digitizer may be relatively large, and even when the area of the opening 630 is small (in the right part of the graph), the maximum magnetic field (G) applied to the digitizer may be relatively large. It may be seen that the width of the magnetization area of the magnet assembly 373 or 473 is about 1 to 2 mm at the middle right of the graph and that the maximum magnetic field (G) applied to the digitizer is the smallest at the point where the area of the opening 630 corresponds to about 1 to 2 mm. This point may also be the point where the area of the opening 630 of the magnet assembly 373 or 473 of the power reception device 520 is substantially equal to the area of the opening 830 of the magnet assembly 800 of the power transmission device 530.

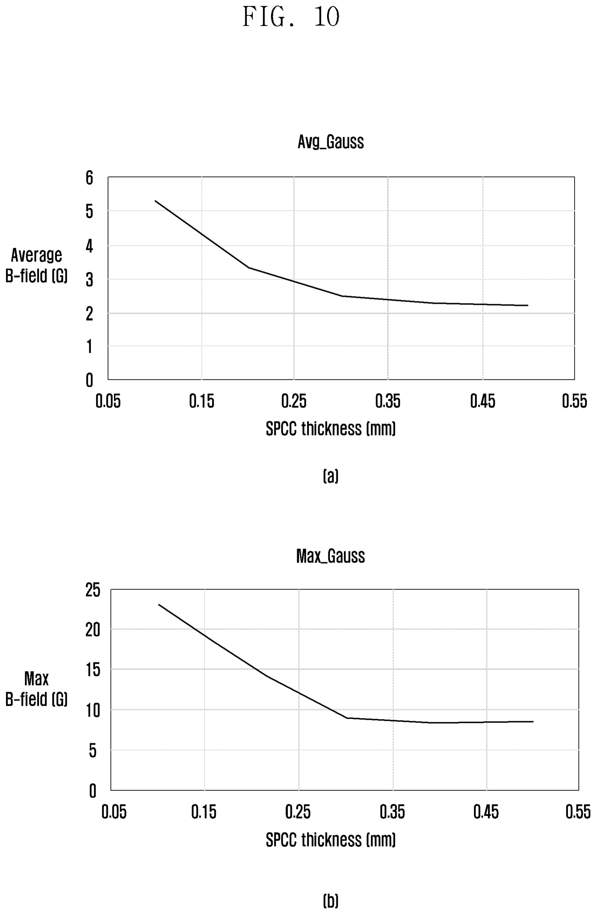

FIGS. 10A and 10B are diagrams illustrating comparison of changes in magnetic field affecting a digitizer depending on the thickness of a first shielding sheet (e.g., the first shielding sheet 391 or 491 in FIG. 3 or 4) according to an embodiment of the disclosure.

Referring to FIGS. 10A and 10B, the horizontal axis of the graph may represent the thickness of the first shielding sheet 391 or 491 of the power reception device 520. For example, the area of the first shielding sheet 391 or 491 will be reduced as the value increases to the right on the horizontal axis. The vertical axis of the graph represents the effect of the magnetic field generated by a magnet assembly (e.g., the magnet assembly 373 or 473 in FIG. 3 or 4) on the digitizer surface, and the graph in FIG. 10A represents the average magnetic field or magnetic flux density (G), and the graph in FIG. 10B may represent the maximum magnetic field or magnetic flux density (G).

Referring to FIGS. 10A and 10B, it may be seen that, as the thickness of the first shielding sheet 391 or 491 increases (in the right part of the graph), the average magnetic field and maximum magnetic field (G) applied to the digitizer may be relatively reduced, but that the average magnetic field and maximum magnetic field (G) are no longer substantially reduced even if the thickness increases at a specific thickness (e.g., about 0.4 mm) or more. Accordingly, it may be seen that the thickness of the first shielding sheet 391 or 491 may be appropriately adjusted, for example, to about 1 mm, while reducing the influence of the magnetic field (G) on the digitizer.

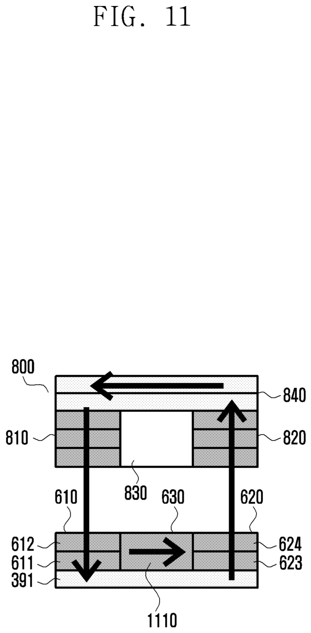

FIG. 11 is a cross-sectional view of a magnet assembly of a power transmission device (e.g., the power transmission device 530 in FIG. 5) and a power reception device (e.g., the power reception device 520 in FIG. 5) according to an embodiment of the disclosure.

According to various embodiments of the disclosure, a magnet assembly (e.g., the magnet assembly 373 or 473 in FIG. 3 or 4) of the power reception device (e.g., the power reception device 520 in FIG. 5) may be coupled to a magnet assembly 800 of the power transmission device (e.g., the power transmission device 530 in FIG. 5), so that a coil (e.g., the coil 370 or 470 in FIG. 3 or 4) of the power reception device 520 and the coil (not shown) of the power transmission device 530 are disposed in alignment for power transmission and reception. The power reception device 520 may include the electronic device 101 disclosed in FIG. 1 (or the electronic device 200 in FIGS. 2A and 2B, the electronic device 300 in FIG. 3, or the electronic device 400 equipped with the case device 401 in FIG. 4). Hereinafter, although the power reception device 520 in FIG. 5 will be described based on the electronic device 300 in FIG. 3 as an example, it may also be applied to the electronic device 400 equipped with the case device 401 in FIG. 4.

According to an embodiment of the disclosure, the magnet assembly 373 or 473 of the power reception device 520 may include a plurality of first magnets 610 disposed to surround the coil 370 or 470, and a plurality of second magnets 620 disposed at a designated distance from the plurality of first magnets 610 so as to surround the plurality of first magnets 610. For example, the designated distance between the plurality of first magnets 610 and the plurality of second magnets 620 may form an opening 630. For example, the opening 630 may be filled with a non-magnetic material. For example, the opening 630 may be filled with a material that is the same as the plurality of first magnets 610 and/or the plurality of second magnets 620 but is not magnetized to have no polarity.

According to an embodiment of the disclosure, a magnet 1110 magnetized in the horizontal direction may be disposed in an area corresponding to the designated distance between the plurality of first magnets 610 and the plurality of second magnets 620. For example, the area of magnet 1110 may be identical to the area of opening 630.

According to an embodiment of the disclosure, the plurality of first magnets 610 may include a first layer 611 and a second layer 612, which is an upper layer of the first layer 611, and the plurality of second magnets 620 may include a third layer 623 and a fourth layer 624 that is an upper layer of the third layer 623. The plurality of first magnets 610 and the plurality of second magnets 620 may be magnetized in vertically opposite directions, and the first layer 611 and the fourth layer 624 may have a first polarity, and the second layer 612 and the third layer 623 may have a second polarity opposite the first polarity.

According to an embodiment of the disclosure, a portion of the magnet 1110 facing the plurality of first magnets 610 may be magnetized in the second polarity, and a portion facing the plurality of second magnets 620 may be magnetized in the first polarity.

According to an embodiment of the disclosure, the magnet assembly 800 of the power transmission device 530 may include a plurality of first magnets 810 corresponding to the plurality of first magnets 610 of the power reception device 520, and a plurality of second magnets 820 corresponding to the plurality of second magnets 620 of the power reception device 520. The plurality of second magnets 820 may be disposed to be spaced a designated distance apart from the plurality of first magnets 810. The designated distance between the plurality of first magnets 810 and the plurality of second magnets 820 may form an opening 830. A shielding sheet 840 may be attached to the magnet assembly 800 of the power transmission device 530.

According to an embodiment of the disclosure, if the power transmission device 530 including the corresponding magnet assembly 800 approaches, the magnet assembly 373 or 473 of the power reception device 520 may produce a closed loop of magnetic flux that starts from the plurality of first magnets 610 of the magnet assembly 373 or 473 and returns back to the plurality of first magnets 610 of the power reception device 520 via the first shielding sheet 391 or 491, the plurality of second magnets 620, and then the magnet assembly 800 of the power transmission device 530.

According to an embodiment of the disclosure, the magnet 1110 disposed in the opening 630 formed in the magnet assembly 373 or 473 of the power reception device 520 may cause the first magnet 610 and the second magnet 620 to form magnetic paths in the vertical direction, and the first shielding sheet 391 or 491 may form a magnetic path in the horizontal direction, thereby forming a closed loop within the magnet assembly 373 or 473 to prevent magnetic flux from leaking to the outside.

According to an embodiment of the disclosure, since the magnet 1110 is disposed between the first magnet 610 and the second magnet 620 of the power reception device 520 such that the magnet 1110 forms a magnetic path in the horizontal direction along with the first shielding sheet 391 or 491, it is possible to sufficiently shield the magnetic field generated from the magnet assembly 373 or 473 even if the first shielding sheet 391 or 491 is relatively thin.

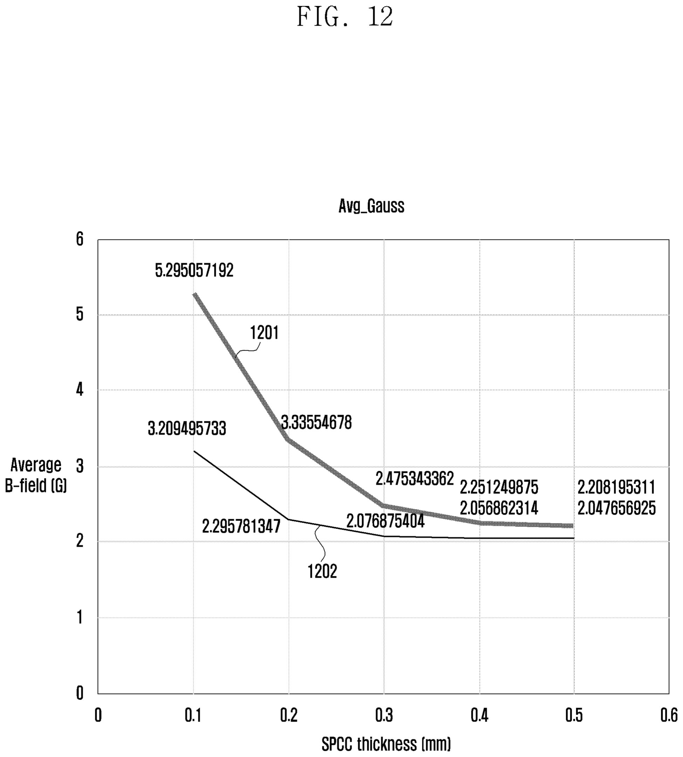

FIG. 12 is a diagram illustrating comparison of changes in magnetic-field affecting a digitizer depending on the thickness of a first shielding sheet (e.g., the first shielding sheet 391 or 491 in FIG. 3 or 4) according to an embodiment of the disclosure.

Referring to FIG. 12, the horizontal axis of the graph may represent the thickness of the first shielding sheet 391 or 491 of the power reception device 520. For example, the area of the first shielding sheet 391 or 491 may be reduced as the value increase to the right on the horizontal axis. The vertical axis of the graph may represent the effect of the magnetic field generated by the magnet assembly (e.g., magnet assembly 373 or 473 in FIG. 3 or 4) on the digitizer surface, for example, the average magnetic field or magnetic flux density (G).

Referring to FIG. 12, the change line 1201 may represent the average magnetic field or magnetic flux density (G) applied to the digitizer depending on the thickness of the first shielding sheet 391 or 491 in FIG. 8.

The change line 1202 in FIG. 12 may represent the average magnetic field or magnetic flux density (G) applied to the digitizer depending on the thickness of the first shielding sheet 391 or 491 in the case where the magnet 1110 is disposed in the area corresponding to the designated distance between the plurality of first magnets 610 and the plurality of second magnets 620 in FIG. 11.

According to various embodiments of the disclosure, referring to the change line 1201 and the change line 1202, it may be seen that the average magnetic field or magnetic flux density (G) applied to the digitizer is reduced as the thickness of the first shielding sheet 391 or 491 increases. In addition, it may be seen that the average magnetic field and maximum magnetic field (G) are no longer substantially reduced even if the thickness increases at a specific thickness (e.g., about 0.4 mm) or more. Accordingly, it may be seen that the thickness of the first shielding sheet 391 or 491 may be appropriately adjusted, for example, to 0.5 mm or less, while reducing the influence of the magnetic field (G) on the digitizer.

According to various embodiments of the disclosure, it may be seen that the average magnetic field or magnetic flux density (G) applied to the digitizer is relatively small in the change line 1202, compared to the change line 1201, even with the same thickness.

According to various embodiments of the disclosure, it may be seen that the average magnetic field or magnetic flux density (G) affecting the digitizer depending on the thickness of the first shielding sheet 391 or 491 is smaller in the case where the magnet 1110 is disposed in the area corresponding to the designated distance between the plurality of first magnets 610 and the plurality of second magnets 620 than in the case where the magnet 1110 is not disposed. Accordingly, in the case where the magnet 1110 is disposed, the first shielding sheet 391 or 491 may be implemented to be thinner.

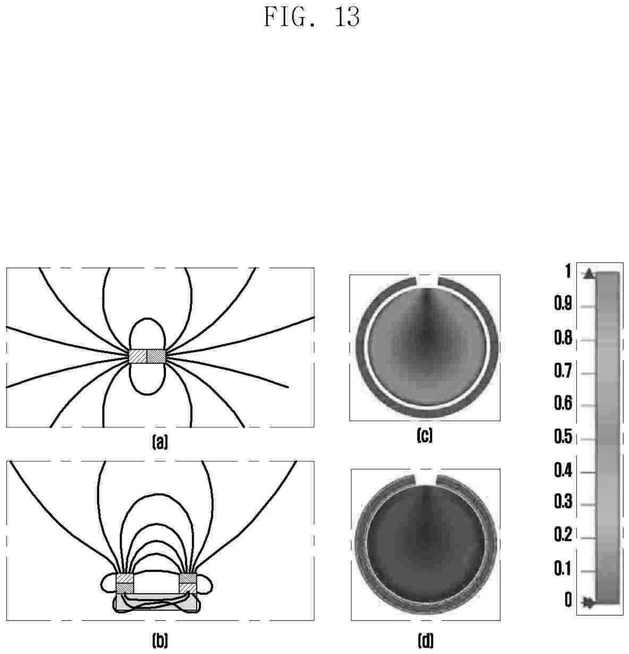

FIG. 13 is a diagram illustrating comparison of magnetic-field saturation of a second shielding sheet depending on the presence or absence of a first shielding sheet according to an embodiment of the disclosure.

Referring to FIG. 13, in the case of a general magnet (a) in which a first shielding sheet (e.g., the first shielding sheet 391 or 491 in FIG. 3 or 4) is not disposed, it may be seen that the magnetic field distributions directed to the outside and inside of an electronic device (e.g., the electronic device 300 or 400 in FIG. 3 or 4) are the same or similar.

According to various embodiments of the disclosure, in the case of a magnet assembly (e.g., the magnet assembly 373 or 473 in FIG. 3 or 4) (b), by disposing a first shielding sheet (e.g., the first shielding sheet 391 or 491 in FIG. 3 or 4), the magnetic field distribution directed to the outside of the electronic device (e.g., the electronic device 300 or 400 in FIG. 3 or 4) may have a greater density than the magnetic field distribution directed to the inside of the electronic device 300 or 400.

Accordingly, in connection with the magnetic-field saturation in a second shielding sheet (e.g., the second shielding sheet 392 or 492 in FIG. 3 or 4), it may be seen that the saturation (d) of the magnet assembly (b) in which the first shielding sheet 391 or 491 is disposed according to various embodiments is lower than the saturation (c) of the general magnet (a) in which the first shielding sheet 391 or 491 is not disposed.

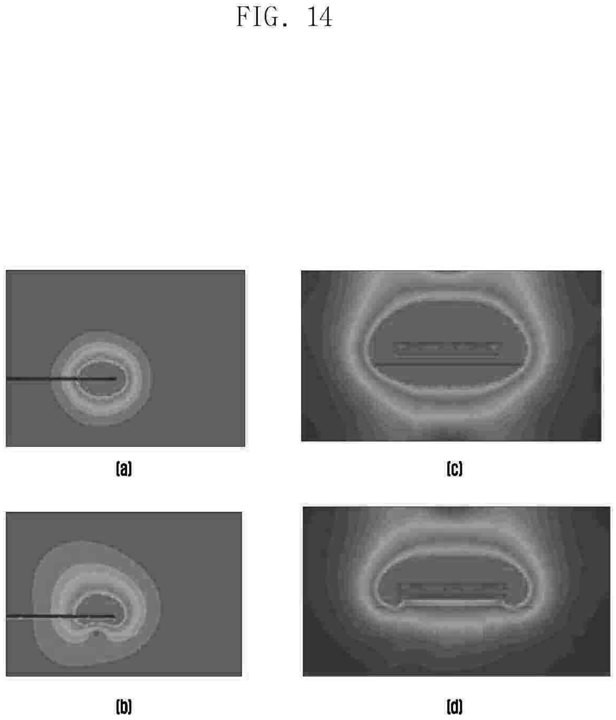

FIGS. 14A and 14B are diagrams illustrating comparison of magnetic-field radiation patterns depending on the presence or absence of a first shielding sheet according to an embodiment of the disclosure.

Referring to FIGS. 14A and 14B, in the case of a magnet assembly in which a first shielding sheet (e.g., the first shielding sheet 391 or 491 in FIG. 3 or 4) is not disposed, the magnetic field distributions directed to the outside and inside of an electronic device (e.g., the electronic device 300 or 400 in FIG. 3 or 4) are the same or similar in the case illustrated in FIG. 14A where a power transmission device (e.g., the power transmission device 530 in FIG. 5) is not coupled and the case illustrated in FIG. 14B where the power transmission device is coupled.

According to various embodiments of the disclosure, in the case of the magnet assembly (e.g., the magnet assembly 373 or 473 in FIG. 3 or 4), it may be seen that, by disposing the first shielding sheet (e.g., the first shielding sheet 391 or 491 in FIG. 3 or 4), the magnetic field distribution directed to the outside of the electronic device 300 or 400 may have a greater density than the magnetic field distribution directed to the inside of the electronic device 300 or 400 in the case illustrated in FIG. 14C where the power transmission device 530 is not coupled and the case illustrated in FIG. 14D where the power transmission device 530 is coupled.

According to various embodiments of the disclosure, the first shielding sheet 391 or 491 attached to the magnet assembly 373 or 473 may perform the function of forming a closed loop of magnetic flux as described above, and may shield the magnetic field radiated from the magnet assembly 373 or 473 toward the electronic device 300 or 400 while strengthening the magnetic field radiated from the back thereof toward the outside of the electronic device 300 or 400, thereby reducing the magnetic field effect on the electronic device 300 or 400 and strengthening the tensile force of the magnet assembly 373 or 473. When the area of the first shielding sheet 391 or 491 is configured to be the same as the area of the magnet assembly 373 or 473, the shielding effect may be further increased.

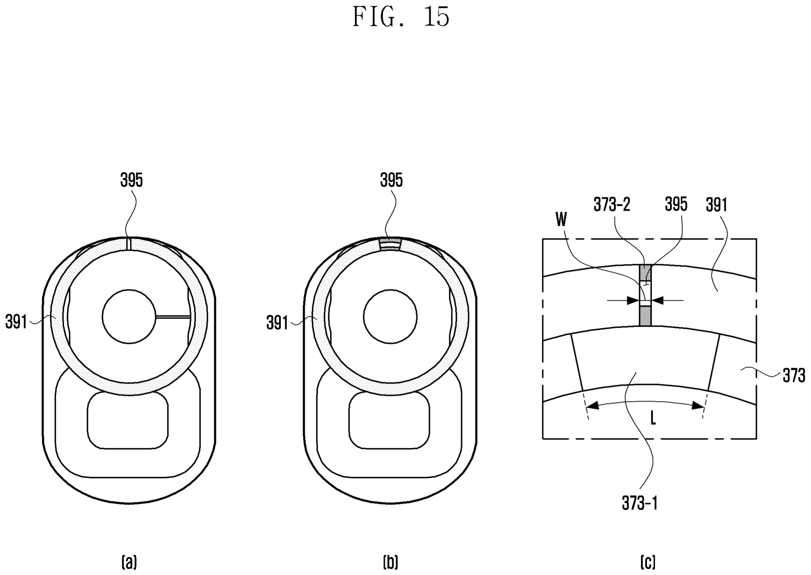

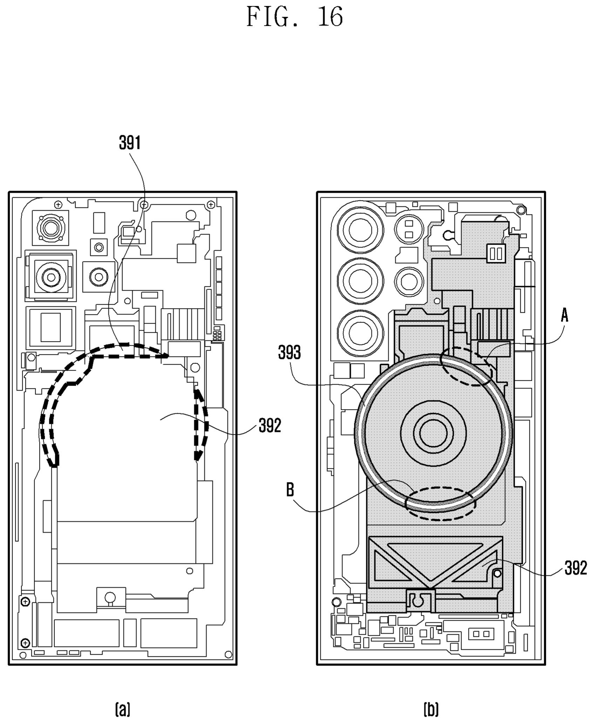

FIGS. 15A, 15B, 15C, 16A, and 16B are diagrams illustrating at least one specific area (e.g., the at least one specific area 395 in FIG. 6C) disposed on a first shielding sheet (e.g., the first shielding sheet 391 or 491 in FIG. 3 or 4) according to various embodiments of the disclosure.

According to various embodiments of the disclosure, when the first shielding sheet 391 or 491 approaches the power transmission device (e.g., the power transmission device 530 in FIG. 5), the wireless charging magnetic field may generate eddy current in the ring-shaped first shielding sheet 391 or 491, so that the power transmission device 530 may recognize the first shielding sheet 391 or 491 as a foreign object (FOD) and stop charging.

According to various embodiments of the disclosure, by disposing at least one specific area 395 on the first shielding sheet 391 or 491 to provide an open effect, it is possible to greatly reduce the eddy current and prevent the charging interruption. If the specific area is not provided, it may cause an eddy current loss of about 161.5 mW. On the other hand, the eddy current loss may be reduced to about 5.011 mW in the case where a specific area of about 0.5 degrees is provided as shown in FIG. 15A and may be reduced to about 4.859mW in the case where a specific area of about 15 degrees is provided as shown in in FIG. 15B.

According to various embodiments of the disclosure, the width W of the first shielding sheet 391 or 491 may be set to, for example, about 0.2 degrees or more and 15 degrees or less. For example, if the width W of the first shielding sheet 391 or 491 is about 0.2 degrees or less, charging may be stopped. For example, if the width W of the first shielding sheet 391 or 491 is about 1.0 degree or less, the eddy current may be about 1.1 mW or less. For example, the width W of the first shielding sheet 391 or 491 may be implemented to have a value as small as possible, for example, 0.5 degrees, based on the magnitude of the eddy current.

According to various embodiments of the disclosure, one magnet may include one first magnet (e.g., the first magnet 373-1 in FIG. 6C) and one second magnet (e.g., the second magnet 373-2 in FIGS. 6C and 15C), and in this case, the width W of at least one specific area 395 may be implemented to be less than the length L of one first magnet 373-1 and/or the second magnet 373-2.

According to various embodiments of the disclosure, a plurality of magnets may be used when assembling the magnet assembly 373 or 473, and in order to ease assembly and reduce the unshielded area, the width W of at least one specific area 395 of the first shielding sheet 391 or 491 may be implemented to be less than the length L of one magnet of the magnet assembly 373 or 473. For example, the width W of at least one specific area 395 of the first shielding sheet 391 or 491 may be implemented to be less than the length L of one magnet 373-1 or 373-2 of the magnet assembly 373 or 473 so that both ends of at least one specific area 395 of the first shielding sheet 391 or 491 may be attached to one magnet 373-1 or 373-2, so one magnet 373-1 or 373-2 may be easily assembled to at least one specific area 395 where the first shielding sheet 391 or 491 is excluded.

According to various embodiments of the disclosure, at least one specific area 395 may be disposed to face the area where the second shielding sheet (e.g., the second shielding sheet 392 or 492 in FIG. 3 or 4) is disposed, excluding the edge thereof.

Referring to FIGS. 16A and 16B, it may be difficult for the second shielding sheet 392 to sufficiently shield the magnetic field generated by the magnet assembly 373 in some edge areas of the disposed area. At least one specific area 395 may be an area where the first shielding sheet 391 or 491 is not disposed and thus is unable to shield the magnetic field of the magnet assembly 373 or 473. Therefore, in order to sufficiently shield the magnetic flux leaking from at least one specific area 395, at least one specific area 395 may be positioned to face the area where the second shielding sheet 392 or 492 is disposed, excluding the edge of the area. For example, at least one specific area 395 may be disposed to face the central area (e.g., area A or area B) where the second shielding sheet 392 or 492 are sufficiently and widely disposed, excluding the edge of the second shielding sheet 392 or 492.

According to various embodiments of the disclosure, an electronic device 300 may include a display 330, a coil 370, a magnet assembly 373 including a plurality of first magnets 610 disposed to surround the coil 370 and a plurality of second magnets 620 disposed to be spaced a designated distance apart from the plurality of first magnets 610 so as to surround the plurality of first magnets 610, a first shielding sheet 391 extending along the magnet assembly 373 toward the display 330 so as to be attached to the magnet assembly 373, a second shielding sheet 392 disposed between the coil 370 and the display 330 toward the display 330 from the first shielding sheet 391, and a third shielding sheet 393 disposed between the display and the second shielding sheet.

According to various embodiments of the disclosure, the first shielding sheet 391 may have an area substantially identical to an area of the magnet assembly 373 formed by the plurality of first magnets 610 and the plurality of second magnets 620.

According to various embodiments of the disclosure, the electronic device may further include a digitizer 333 disposed at a position opposing to the display, and the third shielding sheet 393 may be disposed between the digitizer 333 and the second shielding sheet 392.

According to various embodiments of the disclosure, the electronic device may further include a specific area 395 in a part of the first shielding sheet 391 where no material constituting the first shielding sheet 391 is disposed.

According to various embodiments of the disclosure, a width W of the specific area 395 may be less than or equal to a length L of a first magnet 393-1 or a second magnet 393-2 of the plurality of first magnets 610 and the plurality of second magnets 620.

According to various embodiments of the disclosure, the specific area 395 may be disposed at a position opposing to the first magnet 393-1 and the second magnet 393-2.

According to various embodiments of the disclosure, wherein the specific area 395 may be disposed at a position opposing to a central area of the area where the second shielding sheet 392 is disposed.

According to various embodiments of the disclosure, the first magnet 610 may include a first layer 611 and a second layer 612 that is an upper layer of the first layer 611 and the second magnet 620 may include a third layer 623 and a fourth layer 624 that is an upper layer of the third layer 623, and the first layer 611 and the fourth layer 624 may be magnetized in a first polarity and the second layer 612 and the third layer 623 may be magnetized in a second polarity opposite the first polarity.

According to various embodiments of the disclosure, the electronic device may further include a magnet 1110 disposed in an area corresponding to the designated distance between the plurality of first magnets 610 and the plurality of second magnets 620.

According to various embodiments of the disclosure, the magnet 1110 may be magnetized in the second polarity toward the plurality of first magnets 610 and may be magnetized in the first polarity toward the plurality of second magnets 620.

According to various embodiments of the disclosure, a thickness of the first shielding sheet 391 may be configured to be about 0.5 mm or less, based on the magnet 1110 further included.

According to various embodiments of the disclosure, the first shielding sheet 391 may be disposed to shield a magnetic field generated toward the display 330, and the first shielding sheet 391 may include a specific area in at least a part thereof where no material constituting the first shielding sheet 391 is disposed to reduce eddy current.

According to various embodiments of the disclosure, the magnet assembly 373 may be disposed to be spaced a specified distance apart from the second shielding sheet 392.

According to various embodiments of the disclosure, the designated distance may substantially correspond to an area of an opening 830 formed in a corresponding magnet assembly 800 of an external device 520 including the magnet assembly 800.

According to various embodiments of the disclosure, a case device 401 may include a magnet assembly 473 including a plurality of first magnets 610 disposed to face the electronic device 400 including a coil 470 and surround the coil 470, and a plurality of second magnets 620 disposed to be spaced a designated distance apart from the plurality of first magnets 610 so as to surround the plurality of first magnets 610, and a shielding sheet 491 extending along the magnet assembly 473 toward the electronic device 400 and attached to the magnet assembly.

According to various embodiments of the disclosure, the shielding sheet 491 may have an area substantially identical to an area of the magnet assembly 473 formed by the plurality of first magnets 610 and the plurality of second magnets 620.

According to various embodiments of the disclosure, the device may further include a specific area 395 in a part of the shielding sheet 491 where no material constituting the first shielding sheet is disposed.

According to various embodiments of the disclosure, a width W of the specific area 395 may be less than or equal to a length L of a first magnet 373-1 or a second magnet 373-2 of the plurality of first magnets 610 and the plurality of second magnets 620.

According to various embodiments of the disclosure, the specific area 395 may be disposed at a position opposing to the first magnet 373-1 and the second magnet 373-2.

According to various embodiments of the disclosure, the device may further include a magnet 1110 disposed in an area corresponding to the designated distance between the plurality of first magnets 610 and the plurality of second magnets 620, and the first magnet 610 may include a first layer 611 and a second layer 612 that is an upper layer of the first layer 611 and the second magnet 620 may include a third layer 623 and a fourth layer 624 that is an upper layer of the third layer 623, and the first layer 611 and the fourth layer 624 may be magnetized in a first polarity and the second layer 612 and the third layer 623 may be magnetized in a second polarity opposite the first polarity, and the magnet 1110 may be magnetized in the second polarity toward the plurality of first magnets 610 and is magnetized in the first polarity toward the plurality of second magnets 620. The electronic devices according to various embodiments of the disclosure disclosed in this document may be of various types. The electronic devices may include, for example, portable communication devices (e.g., smartphones), computer devices, portable multimedia devices, portable medical devices, cameras, wearable devices, or home appliances. The electronic devices according to the embodiments of this document are not limited to the above-described devices.

It should be appreciated that various embodiments of the disclosure and the terms used therein are not intended to limit the technological features set forth herein to particular embodiments and include various changes, equivalents, or replacements for a corresponding embodiment. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment of the disclosure, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment of the disclosure, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments of the disclosure, each component (e.g., a module or a program) of the above-described components may include a single entity or multiple entities, and some of the multiple entities may be separately disposed in different components. According to various embodiments of the disclosure, one or more of the above-described components may be omitted, or one or more other components may be added. Alternatively or additionally, a plurality of components (e.g., modules or programs) may be integrated into a single component. In such a case, according to various embodiments of the disclosure, the integrated component may still perform one or more functions of each of the plurality of components in the same or similar manner as they are performed by a corresponding one of the plurality of components before the integration. According to various embodiments of the disclosure, operations performed by the module, the program, or another component may be carried out sequentially, in parallel, repeatedly, or heuristically, or one or more of the operations may be executed in a different order or omitted, or one or more other operations may be added.

## Claims

1. An electronic device (300) comprising:
a display (330);
a coil (370);
a magnet assembly (373) comprising a plurality of first magnets (610) disposed to surround the coil (370) and a plurality of second magnets (620) disposed to be spaced a designated distance apart from the plurality of first magnets (610) so as to surround the plurality of first magnets (610);
a first shielding sheet (391) extending along the magnet assembly (373) toward the display (330) so as to be attached to the magnet assembly (373);
a second shielding sheet (392) disposed between the coil (370) and the display (330) toward the display (330) from the first shielding sheet (391); and
a third shielding sheet (393) disposed between the display and the second shielding sheet.

2. The electronic device according to claim 1, wherein the first shielding sheet (391) has an area substantially identical to an area of the magnet assembly (373) formed by the plurality of first magnets (610) and the plurality of second magnets (620).

3. The electronic device according to claim 1, further comprising a digitizer (333) disposed at a position opposing to the display,
wherein the third shielding sheet (393) is disposed between the digitizer (333) and the second shielding sheet (392).

4. The electronic device according to claim 1, further comprising a specific area (395) in a part of the first shielding sheet (391) where no material constituting the first shielding sheet (391) is disposed.

5. The electronic device according to claim 4, wherein a width (W) of the specific area (395) is less than or equal to a length (L) of a first magnet (393-1) or a second magnet (393-2) of the plurality of first magnets (610) and the plurality of second magnets (620).

6. The electronic device according to claim 5, wherein the specific area (395) is disposed at a position opposing to the first magnet (393-1) and the second magnet (393-2).

7. The electronic device according to claim 4, wherein the specific area (395) is disposed at a position opposing to a central area of the area where the second shielding sheet (392) is disposed.

8. The electronic device according to claim 1, wherein the first magnet (610) comprises a first layer (611) and a second layer (612) that is an upper layer of the first layer (611) and the second magnet (620) comprises a third layer (623) and a fourth layer (624) that is an upper layer of the third layer (623), and the first layer (611) and the fourth layer (624) are magnetized in a first polarity and the second layer (612) and the third layer (623) are magnetized in a second polarity opposite the first polarity.

9. The electronic device according to claim 8, further comprising a magnet (1110) disposed in an area corresponding to the designated distance between the plurality of first magnets (610) and the plurality of second magnets (620).

10. The electronic device according to claim 9, wherein the magnet (1110) is magnetized in the second polarity toward the plurality of first magnets (610) and is magnetized in the first polarity toward the plurality of second magnets (620).

11. The electronic device according to claim 9, wherein a thickness of the first shielding sheet (391) is configured to be about 0.5 mm or less, based on the magnet (1110) further included.

12. The electronic device according to claim 1, wherein the first shielding sheet (391) is disposed to shield a magnetic field generated toward the display (330), and
wherein the first shielding sheet (391) comprises a specific area in at least a part thereof where no material constituting the first shielding sheet (391) is disposed to reduce eddy current.

13. The electronic device according to claim 1, wherein the magnet assembly (373) is disposed to be spaced a specified distance apart from the second shielding sheet (392).

14. The electronic device according to claim 1, wherein the designated distance substantially corresponds to an area of an opening (830) formed in a corresponding magnet assembly (800) of an external device (520) comprising the magnet assembly (800).

15. A case device (401) comprising:
a magnet assembly (473) comprising a plurality of first magnets (610) disposed to face the electronic device (400) comprising a coil (470) and surround the coil (470), and a plurality of second magnets (620) disposed to be spaced a designated distance apart from the plurality of first magnets (610) so as to surround the plurality of first magnets (610); and
a shielding sheet (491) extending along the magnet assembly (473) toward the electronic device and attached to the magnet assembly.
